# EUROPÄISCHE PATENTSCHRIFT

(11) **EP 1 718 784 B1**
(45) Veröffentlichungstag und Bekanntmachung des Hinweises auf die Patenterteilung: **01.12.2021**
(21) Anmeldenummer: 05716769.4
(22) Anmeldetag: 23.02.2005
(51) Int. Cl.: C30B 29/40, C23C 16/455, C30B 25/14

(54) **EINLASSSYSTEM FÜR EINEN MOCVD-REAKTOR**
INLET SYSTEM FOR AN MOCVD REACTOR
SYSTEME D'ADMISSION POUR REACTEUR MOCVD

(30) Priorität: 25.02.2004 DE 102004009130
(43) Veröffentlichungstag der Anmeldung: 08.11.2006
(73) Patentinhaber: Aixtron SE, 52134 Herzogenrath (DE)
(72) Erfinder: DAUELSBERG, Martin, 52074 Aachen (DE); CONOR, Martin, 52066 Aachen (DE); STRAUCH, Gerhard, Karl, 52072 Aachen (DE); KAEPPELER, Johannes, 52146 Wuerselen (DE)
(74) Vertreter: Grundmann, Dirk
(86) Internationale Anmeldenummer: PCT/EP2005/050765
(87) Internationale Veröffentlichungsnummer: WO 2005/080631

(56) Entgegenhaltungen:
- DE-A1- 10 247 921
- JP-A- H09 102 461
- US-A- 4 961 399
- US-A1- 2003 177 977
- US-A1- 2004 013 801
- US-B1- 6 218 212
- PATENT ABSTRACTS OF JAPAN Bd. 017, Nr. 037 (C-1019), 25. Januar 1993 (1993-01-25) -& JP 04 254493 A (NEC CORP), 9. September 1992 (1992-09-09)

## Beschreibung

Die Erfindung betrifft ein Verfahren gemäß Gattungsbegriff des Anspruchs 1.

Gattungsgemäße Verfahren werden von der US 6,218,212 B1, JP 04254493, JP H09 102461 A und DE 100 43 601 A1 offenbart. Die zuletzt genannte Schrift beschreibt eine kreissymmetrische Vorrichtung zum Abscheiden, insbesondere III-V-Halbleiterschichten auf III-V-Halbleitersubstraten. Die bekannte Vorrichtung besitzt eine sich in der Horizontalebene erstreckende kreiszylindrische Prozesskammer. Der Boden der Prozesskammer wird von einem beheizten Substrathalter ausgebildet. Auf dem Substrathalter befinden sich in kreisförmiger Anordnung um das Zentrum desselben eine Vielzahl von Substratträgern. Auf jedem dieser Substratträger können ein oder mehrere Substrate angeordnet werden. Die Substratträger sind drehangetrieben. Die dem Boden der Prozesskammer gegenüberliegende Decke der Prozesskammer kann ebenfalls beheizt sein. Im Zentrum der Decke befindet sich ein Gaseinlassorgan. Dieses ragt bis in die Prozesskammer hinein. Der in die Prozesskammer hineinragende Abschnitt des Gaseinlassorganes ist wassergekühlt. Das Gaseinlassorgan bildet zwei vertikal übereinander liegende Gaseinlasszonen aus. Die unmittelbar über dem Boden angeordnete Einlasszone befindet sich zwischen der Bodenplatte und einer Stirnfläche des Gaseinlassorganes, welche in ihrem Zentrum eine Öffnung hat, aus welcher ein Hydrid zusammen mit einem Trägergas austritt. Bei diesem Hydrid kann es sich um Arsin, Phosphin oder um Ammoniak handeln. Oberhalb dieser Einlasszone befindet sich eine weitere Einlasszone, durch welche ebenfalls gemischt in einem Trägergas ein gasförmiger Ausgangsstoff in die Prozesskammer eingeleitet wird. Bei diesem gasförmigen Ausgangsstoff kann es sich um TMGa, TMIn oder einer anderen metallorganischen Verbindung handeln.

Die JP 04254493 beschreibt zusätzlich eine Vorrichtung, bei der das Substrat nicht auf dem Boden, sondern an der Decke befestigt ist und bei der im Bereich des Bodens eine zusätzliche Gaseinlasszone zum Einleiten von Stickstoff vorgesehen ist.

Auch die US 6,218,212 B1 beschreibt eine dritte Gaseinlasszone, die zwischen einer oberen Gaseinlasszone, durch welche eine Komponente der II Hauptgruppe eingeleitet wird, und einer unteren Gaseinlasszone, durch welche eine Komponente der VI Hauptgruppe eingeleitet wird, angeordnet ist.

Bei typischen Prozessbedingungen ist der Strom des ersten Ausgangsstoffs, der durch die dem Boden der Prozesskammer benachbarte Gaseinlasszone strömt, erheblich größer als derjenige, der durch die zweite Gaseinlasszone strömt. Auch ist der Ausgangsstoff, der durch die erste Gaseinlasszone strömt, erheblich höher konzentriert als der Ausgangsstoff, der durch die zweite Gaseinlasszone strömt, so dass nicht nur die Geschwindigkeit des durch die erste Gaseinlasszone strömenden Gases erheblich größer ist als die Geschwindigkeit des durch die zweite Gaseinlasszone strömenden Gases, sondern sich die Dichten der Gase auch erheblich unterscheiden.

In einer sich unmittelbar an das Gaseinlassorgan anschließenden Einlasszone werden die Ausgangsstoffe thermisch teilweise zerlegt. In dieser Zone findet auch eine Homogenisierung der Strömung bzw. eine Homogenisierung der Gasphase statt. Die beiden Ausgangsstoffe müssen sich durchmischen. In einer sich an der Einlasszone stromabwärts anschließenden Wachstumszone befinden sich die Substrate. In dieser Zone nimmt die Gasphasenkonzentration der Reaktanten und insbesondere der III-Komponente mit zunehmendem Abstand vom Gaseinlassorgan ab. Einhergehend mit dieser Gasphasenverarmung sinkt die Wachstumsrate mit wachsendem Abstand vom Gaseinlassorgan. Eine Kompensation zur Vergleichmäßigung des Wachstums ist durch die Rotation der Substratträger gegeben. Diese Gegebenheiten beschreibt die DE 100 57 134 A1.

Die Lage der Grenze zwischen Einlasszone und Wachstumszone wird durch das Maximum der Wachstumsrate bestimmt. Dieses Maximum liegt dort, wo die Vorzerlegung bzw. die Homogenisierung der Gasphase und des Stroms im Wesentlichen abgeschlossen ist und wo die wachstumslimitierenden Gruppe-III-Ausgangsstoffe durch den dichten hochkonzentrierten Gasstrom aus dem unteren Einlass hindurch diffindiert sind. Das Maximum soll in Stromrichtung kurz vor dem Beginn der Wachstumszone liegen.

Will man die Leistungsfähigkeit der bekannten Vorrichtung dadurch vergrößern, dass man mehr Substrate gleichzeitig beschichten kann, so muss die Ausdehnung der Wachstumszone vergrößert werden. Gleichzeitig muss aber auch das Angebot der Ausgangsstoffe vergrößert werden. Vergrößert man den Gasstrom der Ausgangsstoffe in die Prozesskammer, so verschiebt sich die Grenze zwischen Einlasszone und Wachstumszone weg vom Gaseinlassorgan. Eine derartige Vergrößerung der Gaseinlasszone ist aber unerwünscht, da sich in dieser Zone nicht gewünschte Addukte bilden können. Andererseits darf das Maximum der Wachstumsrate aber nicht innerhalb der Wachstumszone liegen, um ein homogenes Wachstum der Schichten auf den Substraten zu gewährleisten. Darüber hinaus bedingt eine Vergrößerung der Einlasszone entweder eine Verkleinerung der Wachstumszone oder die konstruktive Vergrößerung der ganzen Prozesskammer. Letzteres ist aus Kostengründen unerwünscht.

Der Erfindung liegt somit die Aufgabe zugrunde, Maßnahmen anzugeben, wie die Nutzfläche in einer Prozesskammer vergrößerbar ist. Diese Vergrößerung soll zudem ohne eine Reduzierung der Packungsdichte der Substrate auf dem Substrathalter möglich sein.

Gelöst wird die Aufgabe durch die in den Ansprüchen angegebene Erfindung.

Zunächst und im Wesentlichen ist vorgesehen, dass der erste Ausgangsstoff durch eine dem Boden der Prozesskammer benachbarten und einer der Decke der Prozesskammer benachbarten Gaseinlasszone in die Prozesskammer eingeleitet wird. Zwischen diesen beiden Gaseinlasszonen ist eine mittlere Gaseinlasszone vorgesehen, durch welche der zweite Ausgangsstoff in die Prozesskammer eingeleitet wird. Bei der im Anspruch 10 angegebenen Vorrichtung besitzt die mittlere Gaseinlasszone eine größere vertikale Höhe, als die beiden dem Boden bzw. der Decke benachbarten Gaseinlasszonen. Erfindungsgemäß sind somit drei Gaseinlasszonen vorgesehen. Durch die beiden äußeren, der Decke bzw. dem Boden benachbarten Gaseinlasszonen wird die V-Komponente bzw. das Hydrid in die Prozesskammer eingeleitet. Durch die mittlere, gegebenenfalls mit einer Druckbarriere versehenen Gaseinlasszone wird die III-Komponente in die Prozesskammer eingeleitet. Bei dieser Komponente handelt es sich vorzugsweise um eine metallorganische Verbindung, die in einem Trägergas, beispielsweise Stickstoff oder Wasserstoff gelöst ist. Auch bei der erfindungsgemäßen Vorrichtung oder beim erfindungsgemäßen Verfahren kann der erste Ausgangsstoff in einer 100 bis 5000fach höheren Konzentration in die Prozesskammer eingeleitet werden, als der zweite Ausgangsstoff. Die erfindungsgemäße Vorrichtung kann einen beheizten Boden aufweisen. Die Decke kann entweder beheizt sein oder nicht beheizt sein. Bevorzugt handelt es sich aber um einen Warmwandreaktor mit beheizten Boden und nicht beheizter Decke. Ferner ist es möglich, dass die vertikale Höhe der dem Boden bzw. der Decke benachbarten Gaseinlasszonen geringer ist als die vertikale Höhe der mittleren Gaseinlasszone. Auch kann die Summe der beiden Höhen der den Boden bzw. der Decke benachbarten Gaseinlasszonen kleiner sein als die Höhe der mittleren Gaseinlasszone. Durch die äußeren Gaseinlasszonen kann das Gas mit einer höheren Strömungsgeschwindigkeit als durch die mittlere Gaseinlasszone strömen. Der Reaktor kann einen drehangetriebenen Substrathalter aufweisen, wie ihn die DE 100 43 601 A1 beschreibt. Der Substrathalter kann in gleicher Weise satellitenartig um das Zentrum des Substrathalters angeordnete Substratträger aufweisen. Insgesamt können sechs Substratträger vorgesehen sein, die in kreisförmiger Anordnung eng aneinanderliegend die kreisförmige Einlasszone umgeben. Die Wachstumszone hat dann eine kreisringförmige Gestalt. Jeder einzelne Substratträger kann insgesamt sieben Substrate tragen. Hierdurch wird eine hohe Packungsdichte erreicht. Das Gaseinlassorgan kann ebenso wie beim Stand der Technik wassergekühlt sein, so dass eine sprunghafte Erwärmung des Prozessgases erfolgt, wenn dieses in die Prozesskammer strömt. Das Einlassorgan ist so gestaltet, dass jede der drei oder mehr Einlasszonen individuell mit Gas versorgt werden kann. Hierzu sind entsprechende Massenflussregler und Ventile vorgesehen. Insbesondere die mittlere Gaseinlasszone, die der metallorganischen Komponente zugeordnet ist, kann eine Druckbarriere besitzen. Diese Druckbarriere kann aus einem porösen Material bestehen. Hierdurch wird eine Rückdiffusion vermieden. Das Gaseinlassorgan kann in bekannter Weise eine rotationssymmetrische Gestalt besitzen, wie beispielsweise in der DE 100 64 941 A1 beschrieben wird. Der Substrathalter wird beheizt. Er wird mittelst Strahlung und/oder Wärmeleitung erwärmt. Die Wärme zum Beheizen des Bodens kann infrarot erzeugt werden. Eine elektrische Widerstandsbeheizung ist auch möglich.

Ein Ausführungsbeispiel der Erfindung wird nachfolgend anhand beigefügter Zeichnungen erläutert. Es zeigen:
- Fig. 1: in grob schematischer Darstellung den Querschnitt durch eine Hälfte eines rotationssymmetrischen Reaktors,
- Fig. 2: den radialen Verlauf der Wachstumsrate und
- Fig. 3: die Draufsicht auf einen Substrathalter mit insgesamt sechs Substratträgern, die jeweils mit sieben Substraten bestückt sind.

Das Ausführungsbeispiel zeigt einen rotationssymmetrischen Reaktor, bei dem die Gase im Zentrum eingeleitet werden und bei dem die Gase im Bereich der Peripherie abgeführt werden. Die Erfindung betrifft aber auch solche Reaktoren, die die Form eines Rohres aufweisen, in welches einendseitig das Gas eingeleitet und anderendseitig das Gas abgeleitet wird.

Wesentlich ist ein Gaseinlassorgan 5. Dieses befindet sich dort wo das Gas in die Prozesskammer eingeleitet wird, also bei einer Prozesskammer 1 mit kreissymmetrischer Gestalt im Zentrum. Das Gaseinlassorgan 5 besitzt drei vertikal übereinander angeordnete Gaseinlasszonen 6, 7, 8. Die drei Gaseinlasszonen befinden sich zwischen der Decke 2 und dem Boden 3 der Prozesskammer 1.

Im Ausführungsbeispiel wird der Boden 3 mittels geeigneter Mittel aktiv beheizt.

Die Decke 2 wird indirekt durch den beheizten Boden 3 mittels Strahlung und Wärmeleitung erwärmt. Die Wärme zum Beheizen des Bodens 3 kann infrarot erzeugt werden. Es ist aber auch vorgesehen, die Wärme auf die Art und Weise zu erzeugen, wie sie die DE 100 43 601 A1 beschreibt, nämlich durch Hochfrequenz.

Beim Ausführungsbeispiel durchströmt das Prozessgas die Prozesskammer 1 vom Zentrum zur Peripherie. Zum Abscheiden von III-V-Halbleiter werden durch die Gaseinlasszonen 6, 8, die unmittelbar der Decke 2 bzw. dem Boden 3 benachbart sind, die V-Komponenten als Hydride zugeführt. Insbesondere wird durch die Gaseinlasszonen 6 und 8 PH₃, AsH₃ oder NH₃ eingeleitet.

Durch die zwischen den äußeren Gaseinlasszonen 6 und 8 angeordnete mittlere Gaseinlasszone 7 wird die metallorganische III-er-Komponente eingeleitet, insbesondere wird hier TMG oder TMI oder einer Al-Verbindung eingeleitet.

Mit der Bezugsziffer 11 ist eine kreisringförmige Druckbarriere aus einem porösen, gasdurchlässigem Material bezeichnet. Durch diese strömt die III-er-Komponente zusammen mit dem Trägergas. Das Gas, welches durch die äußeren Gaseinlasszonen 6 und 8 tritt, ist in Dichte und Massenstrom größer als das Gas, welches durch die mittlere Gaseinlasszone 8 in die Prozesskammer 1 hineinströmt. Die Gaseinflüsse in den Gaseinlasszonen 6, 8 lassen sich unabhängig zu dem Gasfluss in der Gaseinlasszone 7 einstellen.

Mit den Bezugsziffern 12 und 13 sind Stege oder Trennelemente bezeichnet, mit denen die durch die Gaseinlasszonen 6, 7, 8 in die Prozesskammer eintretenden Gase getrennt werden. Die Darstellung erfolgt hier nur schematisch. Es sind selbstverständlich solche Gasführungsmittel, wie Rohre oder Kanäle vorgesehen, die in der Lage sind, die durch die Gaseinlasszonen 6, 7, 8 strömenden Gase voneinander getrennt von einer Gasversorgungseinrichtung den Reaktor zu leiten.

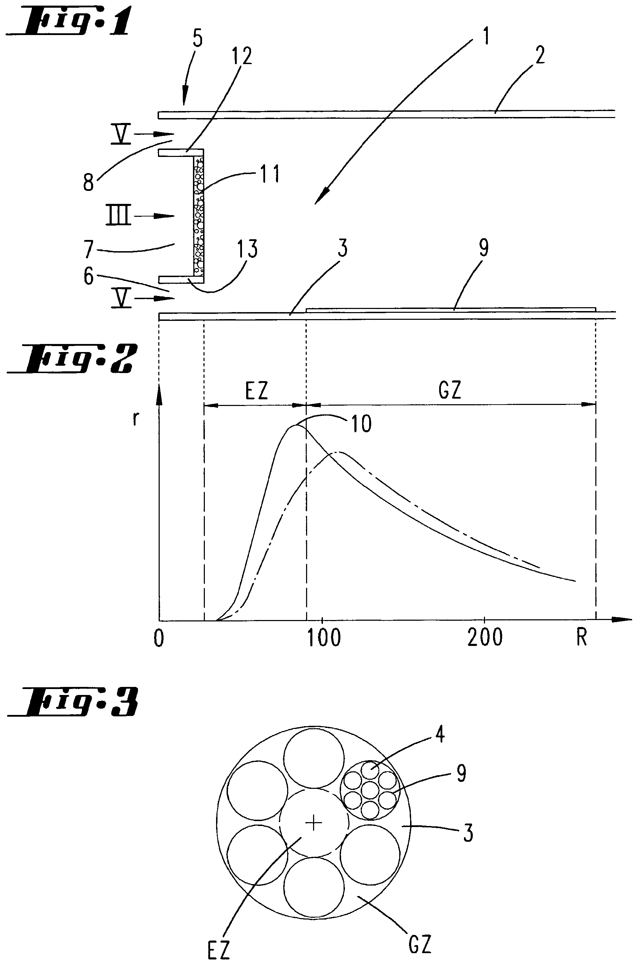

In der Figur 2 ist mit EZ die Einlasszone bezeichnet. Innerhalb dieser Einlasszone mischen sich die aus den Gaseinlasszonen 6 und 8 bzw. 7 in die Prozesskammer eintretenden reaktiven Komponenten. Dies erfolgt im Wesentlichen durch Diffusion. Eine ausreichende Durchmischung ist bis zu der als gestrichelte Linie in der Figur 2 dargestellten Grenze der Einlasszone erreicht. Bis zu dieser Grenze hat sich auch das Strömungsprofil in der Prozesskammer homogenisiert. Die pyrolytisch zerlegbaren Komponenten und insbesondere das schwerer zerlegbare Hydrid, welches durch die Gaseinlasszonen 6 und 8 in die Prozesskammer 1 strömt, haben sich ebenfalls bis zu dieser Grenze teilweise pyrolytisch zerlegt. Die radiale Weite der Einlasszone EZ ist aber so gering, dass eine Addukt-Bildung zwischen den Komponenten in ausreichendem Maß verhindert wird.

Die durchgezogene Kurve in Figur 2 charakterisiert die Wachstumsrate in Abhängigkeit vom Radialabstand vom Zentrum der Prozesskammer 1. Das Maximum 10 der Wachstumsrate r liegt kurz vor der Grenze der Einlasszone EZ. Im Bereich der sich radial auswärts an die Einlasszone EZ anschließenden Wachstumszone GZ sinkt die Wachstumsrate r mit zunehnehmendem radialen Abstand R ab. Dieses Absinken der Wachstumsrate wird durch die Drehung der in der Figur 3 dargestellten kreisscheibenförmigen Substratträger 9 um ihre eigene Achse kompensiert. Die Substratträger 9 können dabei auf einem Gaspolster lagern und - wie in der DE 100 43 601 A1 beschrieben - über Gastrahlen drehangetrieben werden. Zur Vergleichmäßigung der Schichtdicke über den Substraten 4 dient auch die Rotation des gesamten Substrathalters 3, der vom Boden des Prozesskammer 1 gebildet wird, um die Prozesskammerachse.

Wie aus der Figur 3 zu entnehmen ist, haben die einzelnen Substratträger 4 einen Durchmesser der groß genug ist, um in dichtester Packung 7 2" -Substrate aufzunehmen. Insgesamt sind sechs Substratträger in gleichmäßiger Verteilung um das Zentrum des Substrathalters 3 angeordnet.

Die strichpunktiert dargestellte Kurve in Figur 2 zeigt den Verlauf der Wachstumsrate r gegenüber dem radialen Abstand R vom Zentrum der Prozesskammer 1 wie sie beim Stand der Technik verläuft, bei dem ein Gaseinlassorgan verwendet wird, wie es die DE 100 43 601 A1 beschreibt. Durch die zusätzliche Gaseinlasszone 8 für die V-Komponente wandert das Maximum der Wachstumsrate r zu einem geringeren Radialabstand R.

Es ist vorgesehen, dass die vertikalen Höhen der Gaseinlasszonen 6 und 8 jeweils gleich groß sind. Durch diese Gaseinlasszonen 6 und 8 sollen vorzugsweise auch dieselben Gasmengen pro Zeit strömen. Die Höhen der Gaseinlasszonen 6, 8 sind geringer als die Höhe der mittleren Gaseinlasszone 7. Insbesondere ist die Summe der Höhen der Gaseinlasszonen 6 und 8 geringer als die Höhe der mittleren Einlasszone 7.

Modellrechnungen bei einer Vorrichtung des Standes (DE 100 43 601 A1) haben gezeigt, dass die unterschiedlichen Dichten und die großen Unterschiede in den Strömungsgeschwindigkeiten der durch die Gaseinlasszonen in die Prozesskammer eintretenden Gase unterhalb der Decke im Bereich der Einlasszone EZ einen Ringwirbel erzeugen. Es wurde beobachtet, dass ein Gasstrom mit einem Gas, welches durch eine zusätzliche an die Decke 2 angrenzende Gaseinlasszone 8 strömt, diesen Wirbel verhindert. Es entsteht ein in Bezug auf die horizontale Mittelebene der Prozesskammer 1 symmetrisches Strömungsprofil im Bereich der Einlasszone EZ, das sich bis zu der gestrichelt dargestellten Grenze zu einem parabolischen Strömungsprofil homogenisiert.

Die Verhältnisse der Höhen von Gaseinlasszone 6, Gaseinlasszone 7 und Gaseinlasszone 8 zueinander beträgt vorzugsweise 4: 15: 4.

## Patentansprüche

1. Verfahren zum Abscheiden insbesondere kristalliner Schichten auf einem oder mehreren, insbesondere kristallinen Substraten in einer Prozesskammer (1), welche eine Decke (2) und einen dieser vertikal gegenüberliegenden beheizten Boden (3) aufweist, auf welchem die Substrate (4) liegen, bei dem durch vertikal übereinander angeordnete Gaseinlasszonen (6, 7) eines Gaseinlassorganes (5) mindestens ein erster und ein zweiter gasförmiger Ausgangsstoff in die Prozesskammer (1) eingeleitet wird, welche Ausgangsstoffe zusammen mit einem Trägergas die Prozesskammer (1) in Horizontalrichtung durchströmen, wobei der ersten Ausgangsstoff ein Hydrid und der zweite Ausgangsstoff eine metallorganische Verbindung ist, wobei sich der Gasstrom in einer unmittelbar an das Gaseinlassorgan angrenzenden Einlasszone (EZ) homogenisiert und die Ausgangsstoffe zumindest teilweise vorzerlegt werden, deren Zerlegungsprodukte in einer sich an die Einlasszone (EZ) angrenzenden Wachstumszone (GZ) unter stetiger Verarmung des Gasstroms auf den Substraten (4) abgeschieden werden, **dadurch gekennzeichnet, dass** zur Verminderung der horizontalen Erstreckung der Einlasszone (EZ) der erste Ausgangsstoff durch eine dem Boden (3) der Prozesskammer (1) benachbarten Gaseinlasszone (6) und durch eine der Decke (2) der Prozesskammer (1) benachbarten Gaseinlasszone (8) eingeleitet wird, welche Gaseinlasszonen (6, 8) eine geringere Höhe aufweisen, als eine mittlere, zwischen der dem Boden und der Decke angeordneten Gaseinlasszone (7), durch die der zweite Ausgangsstoff in die Prozesskammer (1) eingeleitet wird.

2. Verfahren nach Anspruch 1, **dadurch gekennzeichnet, dass** der erste Ausgangsstoff AₛH₃, PH₃ oder NH₃ ist.

3. Verfahren nach einem der vorhergehenden Ansprüche, **dadurch gekennzeichnet, dass** das Zerlegungsprodukt des ersten Ausgangsstoffes ein Element der Gruppe V oder VI ist und das Zerlegungsprodukt des zweiten Ausgangsstoffes ein Element der Gruppe III oder II ist.

4. Verfahren nach einem der vorhergehenden Ansprüche, **dadurch gekennzeichnet, dass** der erste und/oder der zweite Ausgangsstoff jeweils mittels eines Trägergases durch die ihnen zugeordnete Gaseinlasszone (6, 7, 8) in die Prozesskammer (1) eingeleitet wird.

5. Verfahren nach einem der vorhergehenden Ansprüche, **dadurch gekennzeichnet, dass** der erste Ausgangsstoff in einer 100- bis 5000-fach oder 1000 bis 5000-fach höheren Konzentration in die Prozesskammer eingeleitet wird als der zweite Ausgangsstoff.

6. Verfahren nach einem der vorhergehenden Ansprüche, **dadurch gekennzeichnet, dass** der einen Substrathalter bildende Boden (3) der Prozesskammer (1) von unten beheizt wird.

7. Verfahren nach einem der vorhergehenden Ansprüche, **dadurch gekennzeichnet, dass** der Substrathalter (3) um das Zentrum der Prozesskammer (1) drehangetrieben wird.

8. Verfahren nach einem der vorhergehenden Ansprüche, **dadurch gekennzeichnet, dass** die Zone der maximalen Wachstumsrate (10) radial innerhalb der kreisringförmigen Wachstumszone (WZ) im Randbereich der Einlasszonen (EZ) liegt.

9. Verfahren nach Anspruch 8, **dadurch gekennzeichnet, dass** der Durchmesser der Einlasszone (EZ) geringer ist als die radiale Erstreckung der Wachstumszone (GZ).

10. Vorrichtung zum Durchführen des Verfahrens nach einem der vorhergehenden Ansprüche mit einer Prozesskammer (1), welche eine Decke (2) und einen dieser vertikal gegenüberliegenden beheizbaren Boden (3) aufweist zur Aufnahme der Substrate (4), mit einem Gaseinlassorgan (5), welches vertikal übereinander angeordnete Gaseinlasszonen (6, 7) ausbildet zum voneinander getrennten Einleiten mindestens eines ersten und eines zweiten gasförmigen Ausgangsstoffes, welche Ausgangsstoffe zusammen mit einem Trägergas die Prozesskammer (1) in Horizontalrichtung durchströmen, wobei der erste Ausgangsstoff ein Hydrid und der zweite Ausgangsstoff eine metallorganische Verbindung ist,wobei die Prozesskammer (1) und das Gaseinlassorgan derart ausgebildet sind, dass sich der Gasstrom in einer unmittelbar an das Gaseinlassorgan (5) angrenzenden Einlasszone (EZ) homogenisiert und die Ausgangsstoffe zumindest teilweise vorzerlegt werden und sich die Zerlegungsprodukte in einer sich an die Einlasszone (EZ) angrenzenden Wachstumszone (GZ) unter stetiger Verarmung des Gasstroms auf den Substraten (4) abscheiden, **gekennzeichnet durch** drei übereinander angeordnete Gaseinlasszonen (6, 7, 8) wobei die vertikale Höhe der dem Boden (3) bzw. der Decke (2) benachbarten Gaseinlasszone (6, 8), durch welche der erste Ausgangsstoff in die Prozesskammer eingeleitet wird, geringer ist, als die Höhe der mittleren Gaseinlasszone (7), durch welche der zweite Ausgangsstoff in die Prozesskammer (1) eingeleitet wird.

11. Vorrichtung nach Anspruch 10, **dadurch gekennzeichnet, dass** die Summe der beiden Höhen der am Boden bzw. der Decke benachbarten Gaseinlasszonen (6, 8) kleiner ist als die Höhe der mittleren Gaseinlasszone (7).

12. Vorrichtung nach einem der Ansprüche 10 oder 11, **dadurch gekennzeichnet, dass** die Prozesskammer (1) eine Achssymmetrie aufweist, wobei das Gaseinlassorgan im Zentrum (5) liegt.

13. Vorrichtung nach einem der Ansprüche 10 oder 12, **gekennzeichnet durch** eine Vielzahl von in Umfangsrichtung auf dem Substrathalter (3) nebeneinander angeordnete, kreisscheibenförmige Substratträger (9), welche gegenüber dem Substrathalter (3) drehangetrieben sind und ein oder mehrere Substrate (4) tragen.

14. Vorrichtung nach Anspruch 13, **dadurch gekennzeichnet, dass** jeder Substratträger (9) sieben kreisförmige Substrate (4) trägt und insgesamt sechs oder mehr Substratträger (9) in gleichmäßiger Umfangsverteilung nahe aneinanderliegend dem Substrathalter (3) zugeordnet sind.

## Claims

1. Method for depositing in particular crystalline layers on one or more, in particular crystalline substrates in a process chamber (1) which has a ceiling (2) and a heated floor (3) which is vertically opposite said ceiling and on which the substrates (4) lie, in which method at least a first and a second gaseous starting material are introduced into the process chamber (1) through gas inlet zones (6, 7) of a gas inlet member (5) that are arranged vertically above one another, which starting materials, together with a carrier gas, flow through the process chamber (1) in the horizontal direction, the first starting material being a hydride and the second starting material being an organometallic compound, the gas flow being homogenised in an inlet zone (EZ) directly adjacent to the gas inlet member and the starting materials being at least partially pre-decomposed, the decomposition products of which are deposited on the substrates (4) in a growing zone (GZ) adjacent to the inlet zone (EZ) while the gas flow is continuously depleted, **characterised in that**, in order to reduce the horizontal extension of the inlet zone (EZ), the first starting material is introduced through a gas inlet zone (6) adjacent to the floor (3) of the process chamber (1) and through a gas inlet zone (8) adjacent to the ceiling (2) of the process chamber (1), which gas inlet zones (6, 8) have a lower height than a central gas inlet zone (7) arranged between the floor and the ceiling, through which the second starting material is introduced into the process chamber (1).

2. Method according to claim 1, **characterised in that** the first starting material is AₛH₃, PH₃ or NH₃.

3. Method according to any of the preceding claims, **characterised in that** the decomposition product of the first starting material is an element from group V or VI and the decomposition product of the second starting material is an element from group III or II.

4. Method according to any of the preceding claims, **characterised in that** the first and/or the second starting material is in each case introduced into the process chamber (1) through the gas inlet zone (6, 7, 8) assigned to said material by means of a carrier gas.

5. Method according to any of the preceding claims, **characterised in that** the first starting material is introduced into the process chamber in a concentration which is 100 to 5000 times or 1000 to 5000 times higher than the second starting material.

6. Method according to any of the preceding claims, **characterised in that** the floor (3) of the process chamber (1), which forms a substrate holder, is heated from below.

7. Method according to any of the preceding claims, **characterised in that** the substrate holder (3) is rotationally driven about the centre of the process chamber (1).

8. Method according to any of the preceding claims, **characterised in that** the zone of the maximum growth rate (10) lies radially within the annular growing zone (WZ) in the edge region of the inlet zones (EZ).

9. Method according to claim 8, **characterised in that** the diameter of the inlet zone (EZ) is smaller than the radial extension of the growing zone (GZ).

10. Device for carrying out the method according to any of the preceding claims, comprising a process chamber (1) which has a ceiling (2) and a heated floor (3), which is vertically opposite said ceiling, for receiving the substrates (4), comprising a gas inlet member (5) which forms gas inlet zones (6, 7) arranged vertically above one another for the separate introduction of at least a first and a second gaseous starting material, which starting materials, together with a carrier gas, flow through the process chamber (1) in the horizontal direction, the first starting material being a hydride and the second starting material being an organometallic compound, the process chamber (1) and the gas inlet member being designed in such a way that the gas flow is homogenised in an inlet zone (EZ) directly adjacent to the gas inlet member (5), the starting materials are at least partially pre-decomposed and the decomposition products are deposited on the substrates (4) in a growing zone (GZ) adjacent to the inlet zone (EZ) while the gas flow is continuously depleted, **characterised by** three gas inlet zones (6, 7, 8) arranged above one another, the vertical height of the gas inlet zone (6, 8) adjacent to the floor (3) or the ceiling (2), through which the first starting material is introduced into the process chamber, being lower than the height of the central gas inlet zone (7), through which the second starting material is introduced into the process chamber (1).

11. Device according to claim 10, **characterised in that** the sum of the two heights of the gas inlet zones (6, 8) adjacent to the floor or the ceiling is smaller than the height of the central gas inlet zone (7).

12. Device according to either of claims 10 or 11, **characterised in that** the process chamber (1) has an axial symmetry, the gas inlet member being in the centre (5).

13. Device according to either of claims 10 or 12, **characterised by** a plurality of circular discshaped substrate carriers (9) which are arranged next to one another in the circumferential direction on the substrate holder (3) and which are rotationally driven with respect to the substrate holder (3) and carry one or more substrates (4).

14. Device according to claim 13, **characterised in that** each substrate carrier (9) carries seven circular substrates (4), and a total of six or more substrate carriers (9), in a uniform circumferential distribution close to one another, are associated with the substrate holder (3).

## Revendications

1. Procédé de dépôt de couches, en particulier cristallines, sur un ou plusieurs substrats, en particulier cristallins, dans une chambre de traitement (1) qui présente un plafond (2) et un fond chauffé (3) opposé verticalement à celui-ci, sur lequel reposent les substrats (4), dans lequel au moins un premier et un deuxième matériau de départ gazeux sont introduits dans la chambre de traitement (1) par des zones d'admission de gaz (6, 7) d'un organe d'admission de gaz (5) qui sont agencées verticalement une au-dessus de l'autre, lesquels matériaux de départ s'écoulent ensemble avec un gaz porteur à travers la chambre de traitement (1) dans la direction horizontale, dans lequel le premier matériau de départ est un hydrure et le deuxième matériau de départ est un composé organométallique, dans lequel le flux de gaz est homogénéisé dans une zone d'admission (EZ) directement contiguë à l'organe d'admission de gaz et les matériaux de départ sont au moins partiellement prédécomposés dont les produits de décomposition sont déposés sur les substrats (4) dans une zone de croissance (GZ) jouxtant la zone d'admission (EZ) avec un appauvrissement continu du flux de gaz, **caractérisé en ce que**, pour réduire l'étendue horizontale de la zone d'admission (EZ), le premier matériau de départ est introduit à travers une zone d'admission de gaz (6) adjacente au fond (3) de la chambre de traitement (1) et à travers une zone d'admission de gaz (8) adjacente au plafond (2) de la chambre de traitement (1), lesquelles zones d'admission de gaz (6, 8) ont une hauteur inférieure à celle d'une zone d'admission de gaz centrale (7) agencée entre le fond et le plafond, à travers laquelle le deuxième matériau de départ est introduit dans la chambre de traitement (1).

2. Procédé selon la revendication 1, **caractérisé en ce que** le premier matériau de départ est AₛH₃, PH₃ ou NH₃.

3. Procédé selon l'une des revendications précédentes, **caractérisé en ce que** le produit de décomposition du premier matériau de départ est un élément du groupe V ou VI et le produit de décomposition du deuxième matériau de départ est un élément du groupe III ou II.

4. Procédé selon l'une des revendications précédentes, **caractérisé en ce que** le premier et/ou le deuxième matériau de départ est chacun introduit dans la chambre de traitement (1) au moyen d'un gaz porteur à travers la zone d'admission de gaz (6, 7, 8) qui lui est attribuée.

5. Procédé selon l'une des revendications précédentes, **caractérisé en ce que** le premier matériau de départ est introduit dans la chambre de traitement à une concentration 100 à 5000 fois ou 1000 à 5000 fois supérieure à celle du deuxième matériau de départ.

6. Procédé selon l'une des revendications précédentes, **caractérisé en ce que** le fond (3) de la chambre de traitement (1) formant un support de substrat(s) est chauffé par le bas.

7. Procédé selon l'une des revendications précédentes, **caractérisé en ce que** le support de substrat (s) (3) est entraîné en rotation autour du centre de la chambre de traitement (1).

8. Procédé selon l'une des revendications précédentes, **caractérisé en ce que** la zone à vitesse de croissance maximale (10) est située radialement à l'intérieur de la zone de croissance annulaire (WZ) dans la région périphérique des zones d'admission (EZ).

9. Procédé selon la revendication 8, **caractérisé en ce que** le diamètre de la zone d'admission (EZ) est inférieur à l'extension radiale de la zone de croissance (GZ).

10. Dispositif pour la mise en œuvre du procédé selon l'une des revendications précédentes, avec une chambre de traitement (1) qui présente un plafond (2) et un fond (3) chauffable, situé verticalement à l'opposé du plafond, pour recevoir les substrats (4), avec un organe d'admission de gaz (5) qui forme des zones d'admission de gaz (6, 7) agencées verticalement une au-dessus de l'autre pour l'introduction séparée d'au moins un premier et un deuxième matériau de départ gazeux, lesquels matériaux de départ traversent ensemble avec un gaz porteur la chambre de traitement (1) dans la direction horizontale, dans lequel le premier matériau de départ est un hydrure et le deuxième matériau de départ est un composé organométallique, dans lequel la chambre de traitement (1) et l'organe d'admission de gaz sont formés de telle manière que le flux de gaz est homogénéisé dans une zone d'admission (EZ) directement contiguë à l'organe d'admission de gaz (5) et que les matériaux de départ sont au moins partiellement prédécomposés et que les produits de décomposition sont déposés sur les substrats (4) dans une zone de croissance (GZ) jouxtant la zone d'admission (EZ) avec un appauvrissement continu du flux de gaz, **caractérisé par** trois zones d'admission de gaz (6, 7, 8) agencées une au-dessus de l'autre, dans lequel la hauteur verticale des zones d'admission de gaz (6, 8) adjacentes respectivement au sol (3) et au plafond (2) par lesquelles le premier matériau de départ est introduit dans la chambre de traitement, est inférieure à la hauteur de la zone d'admission de gaz centrale (7) par laquelle le deuxième matériau de départ est introduit dans la chambre de traitement (1).

11. Dispositif selon la revendication 10, **caractérisé en ce que** la somme des deux hauteurs des zones d'admission de gaz (6, 8) adjacentes respectivement au sol et au plafond est inférieure à la hauteur de la zone d'admission de gaz centrale (7).

12. Dispositif selon l'une des revendications 10 ou 11, **caractérisé en ce que** la chambre de traitement (1) présente une symétrie axiale, l'organe d'admission de gaz étant situé au centre (5).

13. Dispositif selon l'une des revendications 10 ou 12, **caractérisé par** une pluralité de porte-substrats (9) en forme de disques circulaires agencées côte à côte dans la direction circonférentielle sur le support de substrats (3), qui sont entraînés en rotation par rapport au support de substrats (3) et portent un ou plusieurs substrats (4).

14. Dispositif selon la revendication 13, **caractérisé en ce que** chaque porte-substrats (9) porte sept substrats circulaires (4) et un total de six porte-substrats (9) ou plus sont associés au support de substrats (3) en proximité étroite les uns des autres dans une distribution circonférentielle uniforme.
